Europäisches Patentamt

European Patent Office

Office européen des brevets

(11) Numéro de publication: **0 216 662 B1**

## FASCICULE DE BREVET EUROPEEN

(12)

(45) Date de publication de fascicule du brevet:
**02.05.91**

(21) Numéro de dépôt: **86401821.3**

(22) Date de dépôt: **14.08.86**

(51) Int. Cl.⁵: **G01R 31/36**

(54) Dispositif de contrôle d'une batterie d'accumulateurs.

(30) Priorité: **23.08.85 FR 8512679**

(43) Date de publication de la demande:
**01.04.87 Bulletin 87/14**

(45) Mention de la délivrance du brevet:
**02.05.91 Bulletin 91/18**

(84) Etats contractants désignés:
**DE GB IT NL SE**

(56) Documents cités:
**EP-A- 0 012 315**
**FR-A- 2 361 754**
**FR-A- 2 534 381**
**GB-A- 2 147 109**

**PATENTS ABSTRACTS OF JAPAN, vol. 5, no.
109 (E-65)[781], 15 juillet 1981; & JP-A-56 48
076 (TOKYO SHIBAURA DENKI K.K.)
01-05-1981**

(73) Titulaire: **Abiven, Jacques
Coat Mael Vieux Marché
F-22420 Plouaret(FR)**

Titulaire: **Audrain, Eric
C.341 Kervo alan
F-22700 Perros Guirec(FR)**

(72) Inventeur: **Abiven, Jacques
Coat Mael Vieux Marché
F-22420 Plouaret(FR)**
Inventeur: **Audrain, Eric
C.341 Kervo alan
F-22700 Perros Guirec(FR)**

(74) Mandataire: **Martinet & Lapoux
62, rue des Mathurins
F-75008 Paris(FR)**

Rank Xerox (UK) Business Services

## Description

La présente invention concerne d'une manière générale un dispositif de contrôle pour surveiller des paramètres caractérisant l'état d'une batterie en vue de recharger périodiquement avec un courant élevé la batterie et de signaler une quelconque défaillance de celle-ci.

Plus particulièrement, l'invention a trait à un dispositif de contrôle d'une batterie d'accumulateurs comprenant un circuit de surveillance de régime pour fournir des impulsions de signal d'horloge ayant une fréquence variable proportionnelle à un courant de charge et décharge de la batterie, un circuit de commande pour estimer la capacité instantanée de la batterie en fonction d'un comptage-décomptage d'impulsions du signal d'horloge, et un circuit de régulation pour recharger la batterie à partir d'une tension de secteur dès que la capacité instantanée est égale à une première capacité sensiblement inférieure à une capacité maximale de la batterie.

Selon la technique antérieure, la capacité instantanée de la batterie dans un tel dispositif est généralement évaluée directement en proportion du courant de charge et décharge. Cependant, la capacité disponible de la batterie est toujours inférieure à la capacité de la batterie en charge. Le rapport de la capacité disponible à la capacité chargée appelé rendement varie en fonction de la température surtout lorsque la batterie est à pleine charge, et décroît rapidement lorsque la température ambiante augmente. En particulier le courant d'autodécharge croît d'autant plus que la température ambiante est élevée. Aussi, une évaluation de la capacité instantanée sans considération du rendement et de la température sous-estime et altère considérablement la mesure de capacité de laquelle dépend la recharge cyclique de la batterie. Sans soumettre la batterie à une surcharge exagérée pouvant détériorer la batterie, il est aussi d'intérêt de recharger la batterie à une capacité maximale correspondant à un taux de surcharge convenable. De plus, il est également souhaitable que la recharge de la batterie soit commandée en fonction de la température de sorte que l'amplitude du courant de recharge soit d'autant plus important que la température est élevée et que le rendement énergétique de la batterie est faible.

La demande FR-A-2361754 divulgue un dispositif de contrôle de batterie tel que défini dans le préambule de la revendication 1 et dans lequel les inconvénients précités de la technique antérieure sont partiellement évités. En effet, dans le dispositif selon la FR-A-2361754 l'influence de la température sur le rendement énergétique de la batterie est prise en compte. Néanmoins, cette influence n'est prise en compte que pendant le régime de charge et l'estimation du courant de décharge n'est pas fonction de la température.

La présente invention vise à fournir un dispositif de contrôle de batterie dans lequel les inconvénients selon la technique antérieure sont complètement éliminés et qui est conçu pour une recharge optimale de la batterie en fonction d'un taux de surcharge de la batterie et de la température.

A cette fin, un dispositif de contrôle de batterie selon l'invention est tel que défini et caractérisé dans la revendication 1.

De préférence, le dispositif de contrôle comprend également un circuit d'évaluation de vieillissement pour évaluer le vieillissement de la batterie par comptage d'impulsions dont la fréquence de répétition dépend de la température, du courant de charge et décharge, et de la capacité estimée de la batterie, afin de produire et transmettre un signal d'alarme lorsque le nombre d'impulsions comptées atteint une valeur prédéterminée.

La régulation de la charge de la batterie est effectuée en fonction non seulement de l'amplitude du courant de charge et décharge mais également en fonction de la température afin d'obtenir une surcharge convenable mais non permanente.

Le circuit de commande recharge périodiquement la batterie notamment afin de compenser le courant d'autodécharge variant avec la température. Le circuit de commande peuvent comprendre un circuit de comptage-décomptage ayant un compte maximal représentatif de la capacité maximale de la batterie pour compter et décompter les impulsions du signal d'horloge, des moyens pour détecter ledit compte maximal, des moyens pour détecter un premier compte dans le circuit de comptage-décomptage représentatif de la première capacité, et des moyens pour autoriser les moyens pour recharger à recharger la batterie dès que le compte du circuit de comptage et décomptage est inférieur au premier compte, puis tant que ledit compte n'est pas égal au compte maximal.

Le circuit de régulation peut comprendre un limiteur de courant de charge incluant en entrée une thermistance en parallèle avec un premier contact, le premier contact étant fermé lorsque la batterie est en régime de décharge et a une capacité inférieure à la capacité maximale, et étant ouvert lorsque la batterie est en régime de charge, et un amplificateur ayant une entrée reliée à une sortie du limiteur de courant et à la terre à travers un second contact commandé par le circuit de commande, une entrée de contre-réaction recevant ladite tension amplifiée appliquée par le circuit d'amplification et proportionnelle à un courant de charge et décharge, et une sortie reliée à une entrée de commande du régulateur de charge, le second contact étant ouvert dès que la capacité de la batterie est inférieure à ladite première capacité, puis tant que la capacité de la batterie n'est pas égale à la capacité maximale.

Le dispositif de contrôle surveille également d'autres paramètres de la batterie, comme on le verra dans la suite, en vue de prévenir une décharge de la batterie lorsque la tension aux bornes de la batterie est inférieure à une tension de référence prédéterminée et la capacité résiduelle de la batterie pratiquement déchargée est très faible. Par exemple, la batterie est jugée "bonne" par le dispositif, lorsque la tension aux bornes de la batterie est de l'ordre de 60% de la tension à pleine charge et la capacité de la batterie est de l'ordre de 20% de la capacité initiale maximale.

D'autres caractéristiques et avantages de la présente invention apparaîtront plus clairement à la lecture de la description suivante de plusieurs réalisation préférées de l'invention en référence aux dessins annexés correspondants dans lesquels :

- la Fig.1 est un bloc diagramme d'un dispositif de contrôle de batterie selon l'invention ;
- la Fig.2 montre en détail un circuit de surveillance de régime de batterie inclus dans le dispositif ;
- la Fig.3 montre en détail un circuit de commande de charge inclus dans le dispositif ;
- la Fig.4 montre en détail un circuit de régulation de charge et un circuit de coupure de décharge inclus dans le dispositif ; et
- la Fig.5 montre en détail un circuit d'indication de durée de vie de la batterie inclus dans le dispositif.

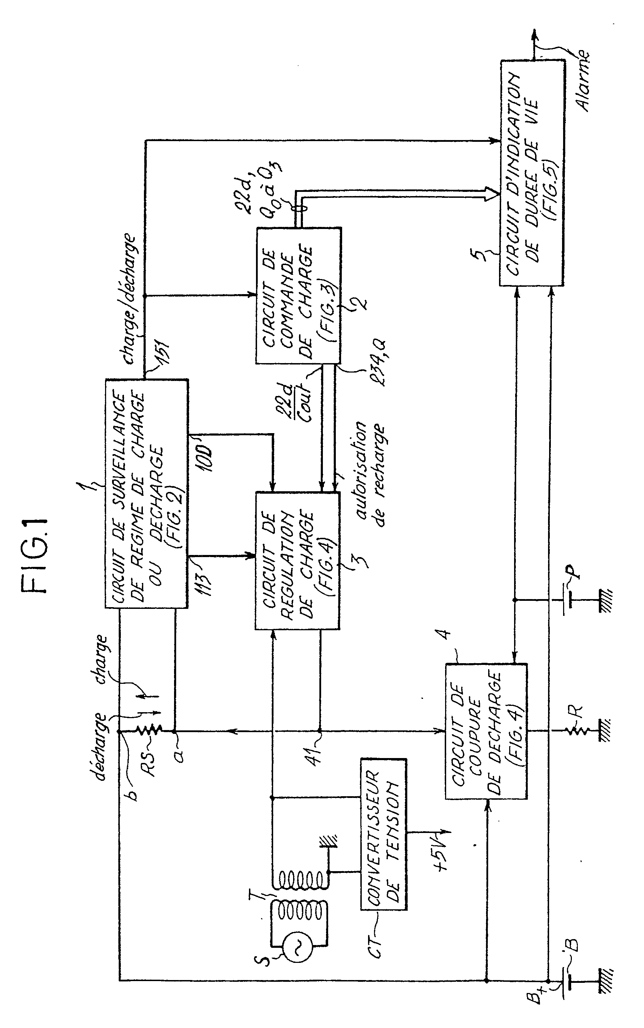

Comme montré à la Fig. 1, un dispositif de contrôle contrôlant une batterie d'accumulateurs B comporte essentiellement une boucle de circuits 1, 2 et 3 pour recharger par régulation automatique la batterie, un circuit de coupure de décharge 4 pour déconnecter la batterie B d'un circuit d'utilisation, ici représenté à titre d'exemple par une résistance de charge R, et un circuit d'indication de durée de vie 5. La plupart des circuits inclus dans le dispositif de contrôle sont alimentés par un convertisseur de tension CT fournissant à partir du secteur alternatif S une tension continue de 5 Volts. Une source d'alimentation autonome, telle qu'une pile du type "memoguard" P de 3 Volts, autorisant une autonomie du dispositif de contrôle de 18 ans environ, alimente des composants électroniques dans le circuit 5 et sert également de source de tension de référence, comme on le verra dans la suite.

Des valeurs numériques typiques sont indiquées dans la suite de la description à titre d'exemple, pour une batterie supportant des régimes de charge à courant élevé, composée de cinq éléments étanches au cadmium-nickel, ayant une tension nominale au repos de 6 Volts et une tension en charge de 6,6 Volts.

La boucle de régulation comprend un circuit de surveillance de régime de charge ou décharge de batterie 1, un circuit de commande de charge 2 et un circuit de régulation de charge 3. Le circuit de surveillance 1 détecte un régime de charge et un régime de décharge de la batterie en analysant un courant traversant une résistance shunt RS ayant une faible valeur ohmique, typiquement d'un Ohm, très faible par rapport à celle de la résistance de charge R. En régime de charge, un courant de charge est prélevé sous une tension de 10 Volts aux bornes d'un enroulement secondaire d'un transformateur T relié au secteur S de 220 Volts et est redressé et régulé dans le circuit de régulation 3 pour être appliqué à la batterie B à travers la résistance shunt RS. En régime de décharge, faisant suite à une interruption du secteur, un courant de décharge produit par la batterie B traverse la résistance shunt RS suivant un sens contraire à celui du courant de charge, et est fourni à la résistance de charge R à travers le circuit de coupure 4 à l'état conducteur.

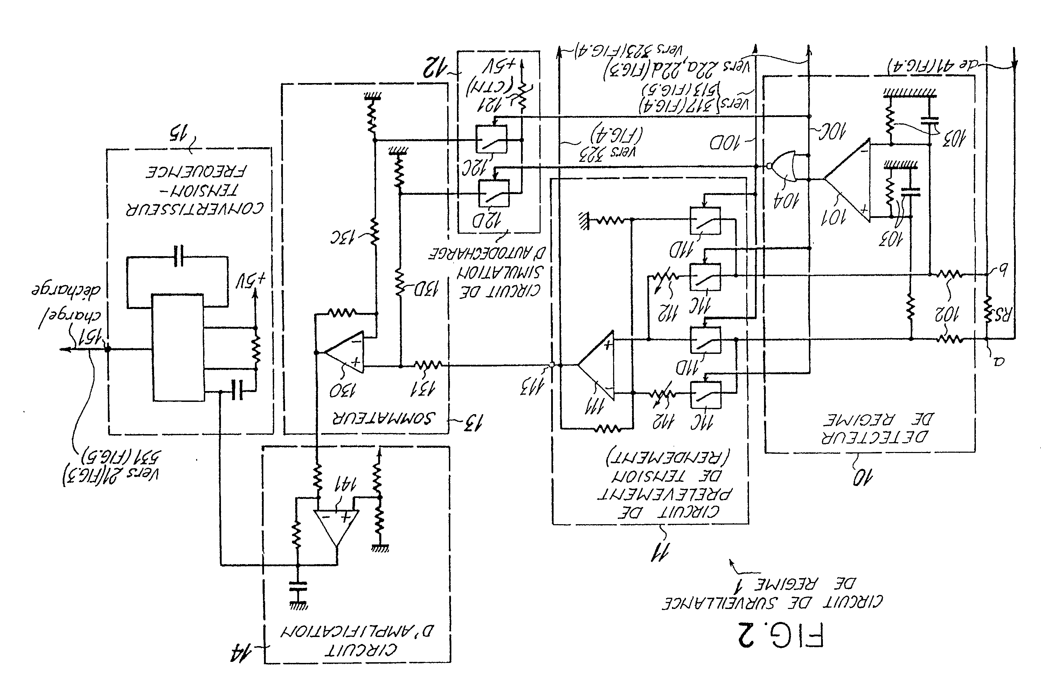

En référence à la Fig.2, le circuit de surveillance de régime 1 comprend un détecteur de régime de batterie 10, un circuit de prélèvement de tension 11, un circuit de simulation d'autodécharge 12, un sommateur 13, un circuit d'amplification 14 et un convertisseur tension-fréquence 15.

Le détecteur 10 détecte le sens du courant dans la résistance shunt RS. Lorsqu'un courant circule suivant le sens du circuit de régulation 3 vers la batterie B à travers la résistance RS, une première sortie 10C du détecteur 10 est à l'état logique haut "1" pour indiquer un régime de charge de la batterie B. A contrario, lorsqu'un courant circule suivant le sens de la batterie B vers la résistance de charge R à travers la résistance RS, une seconde sortie 10D du détecteur 10 est à l'état "1" pour indiquer un régime de décharge de la batterie B. Le détecteur 10 est essentiellement constitué par un comparateur de tension incluant un amplificateur opérationnel 101 ayant deux bornes d'entrée reliées respectivement aux bornes a et b de la résistance RS à travers des résistances 102 et deux circuits d'entrée sensiblement différents à résistance et condensateur parallèles 103, et ayant pour borne de sortie, la sortie 10C reliée à un inverseur 104 à sortie 10D.

Le circuit de prélèvement 11 comprend en entrée, un circuit de commutation ayant deux paires de simples contacts parallèles 11C et 11D, et en sortie, un amplificateur opérationnel 111. Le circuit de commutation prélève la tension aux bornes de la résistance shunt RS à travers laquelle circule un courant de charge ou décharge, et inverse cette tension en régime de décharge afin que l'amplificateur 111 amplifie la tension prélevée quelle que soit sa polarité. Dans le circuit 11, les premier et second contacts 11C sont fermés lors-

que la sortie d'indication de charge 10C est à l'état "1" afin de relier respectivement les première et seconde bornes a et b de la résistance RS à travers les résistances 102 à des bornes d'entrée inverse "-" et directe "+" de l'amplificateur 111 à travers deux résistances identiques 112. En régime de décharge, lorsque la sortie 10D est à l'état "1", les premier et second contacts 11D sont fermés pour relier les première et seconde bornes a et b de la résistance RS à travers les résistances 102 directement aux bornes directe "+" et inverse "-" de l'amplificateur 111. L'amplificateur 111 offre un gain inversement proportionnel à la somme des valeurs ohmiques des résistances 102, en parallèle avec les résistances 103, et des résistances 112, en régime de charge, et inversement proportionnel à la valeur ohmique des résistances 102, en parallèle avec les résistances 103, en régime de décharge. Les résistances 102, en parallèle avec les résistances 103, et les résistances 112 sont ainsi choisies pour compenser la chute de rendement de la batterie B, particulièrement au voisinage de la charge maximale. Typiquement, les résistances 102, en parallèle avec les résistances 103, et les résistances 112 ont des valeurs ohmiques égales à 100 et 10 kOhm respectivement, correspondant à un rendement en énergie ou rapport de capacité maximale disponible sur capacité chargée égal à 100/120. Les résistances 112 peuvent être remplacées chacune par un composant non linéaire, tel que varistance, afin d'ajuster les niveaux de rendement en charge.

Une tension proportionnelle à un courant de charge corrigé par la chute de rendement de la batterie, ou à un courant de décharge est ainsi délivrée par une borne de sortie 113 de l'amplificateur 111 pour être appliquée à une entrée directe "+" d'un amplificateur opérationnel 130 à travers une résistance d'entrée 131 dans le sommateur 13. L'amplificateur 130 fonctionne soit en soustracteur lorsque la batterie est en régime de charge, soit en additionneur lorsque la batterie est en régime de décharge, afin de prendre en compte une autodécharge permanente de la batterie B.

Dans le circuit de simulation 12 est prévue une thermistance 121 constituée par une résistance à coefficient de température négatif (CTN) ayant une borne portée à 5 Volts. Une autre borne de la thermistance 121 est reliée d'une part, à une borne inverse "-" de l'amplificateur 130 à travers un contact 12C et une seconde résistance d'entrée 13C dans le sommateur 13, et d'autre part, à la borne directe "+" de l'amplificateur 130 à travers un contact 12D et une troisième résistance d'entrée 130 dans le sommateur 13. La caractéristique de variation résistance-température de la thermistance 121 est choisie de sorte qu'elle soit proche d'une caractéristique exponentielle courant d'autodécharge-température de la batterie B afin que dans la valeur du courant de charge ou décharge estimée par le circuit de surveillance 1, le courant d'autodécharge de la batterie soit pris en compte. Comme on le verra dans la suite, le courant de charge ou de décharge corrigé par la perte de rendement de charge et le courant d'autodécharge permet d'évaluer à tout instant la capacité "théorique" de la batterie dans le circuit de commande de charge 2.

Le contact 12C, comme les contacts 11C, est fermé en régime de charge sous la commande de la sortie 10C du détecteur de régime 10, ce qui met le sommateur 13 en fonctionnement de soustracteur ; le sommateur soustrait une tension "d'autodécharge" établie par la thermistance 121 à la tension "de charge" délivrée par l'amplificateur 111 pour obtenir une tension "de charge théorique" délivrée par une sortie de l'amplificateur 130. En régime de décharge, le contact 12D comme les contacts 11D est fermé sous la commande de la sortie 10D du détecteur de régime 10 ; le sommateur fonctionne alors en additionneur pour additionner la tension "de décharge" délivrée par l'amplificateur 111 et la tension "d' autodécharge" en une tension "de décharge théorique" délivrée par la sortie de l'amplificateur 130.

Puis la tension de charge ou décharge théorique est amplifiée dans le circuit d'amplification 14 incluant un amplificateur opérationnel non inverseur 141 et est convertie linéairement en fréquence dans le convertisseur tension-fréquence 15. Le convertisseur 15 fonctionne linéairement sur trois décades de fréquence et fournit à une sortie 151 un signal d'horloge ayant typiquement une fréquence comprise entre 1,2 Hz et 1,2 kHz. La fréquence du signal d'horloge est d'autant plus grande que le courant de charge théorique est grand afin de recharger rapidement la batterie et éviter une surcharge intempestive de la batterie, ou que le courant de décharge théorique est grand afin de stopper rapidement toute décharge de la batterie dès que la capacité instantanée de la batterie atteint un seuil théorique de décharge fixé à au plus 20% de sa capacité théorique nominale. En cas de non utilisation de la batterie, le signal d'horloge a une fréquence relativement faible porportionnelle au courant d'autodécharge simulé.

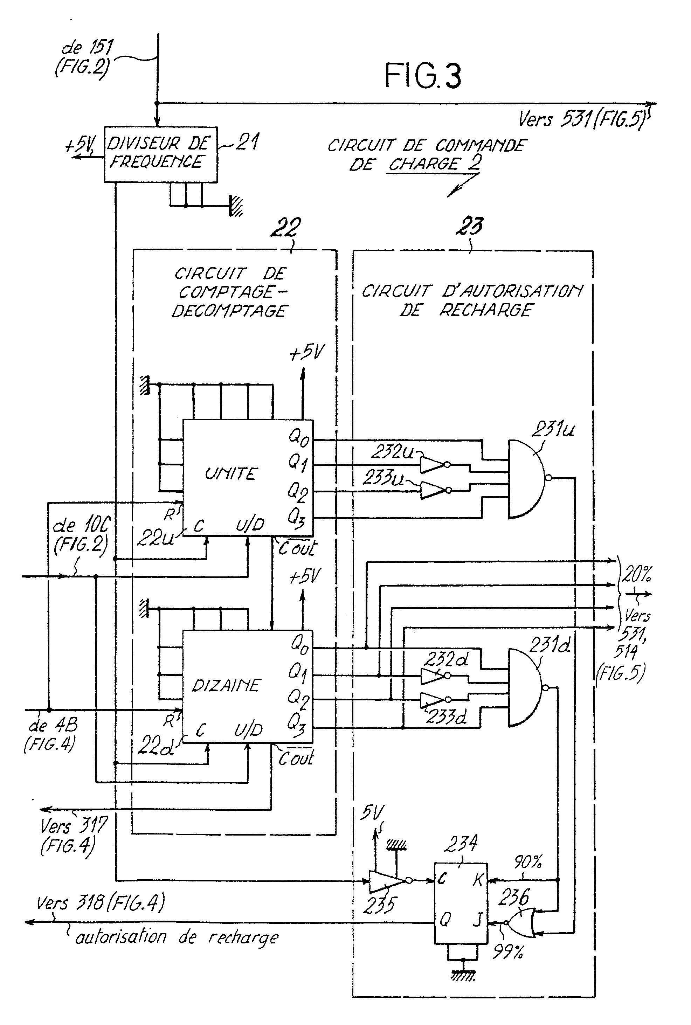

Comme montré à la Fig.3, le circuit de commande de charge 2 comprend un diviseur de fréquence 21, un circuit de comptage-décomptage 22 à compte maximal égal à 99 et un circuit logique d'autorisation de recharge 23. Le diviseur de fréquence 21 divise la fréquence variable du signal d'horloge délivrée par la sortie 151 du convertisseur tension-fréquence 15 typiquement par $2^{19}$. Le diviseur 21 applique un second signal d'horloge ayant des fréquences comprises entre $2,3 \cdot 10^{-6}$ et

2,3 $10^{-3}$ Hz à des entrées d'horloge C de deux compteurs-décompteurs décimaux en cascade 22u et 22d dans le circuit 22. Les compteurs-décompteurs 22u et 22d produisent par quatre sorties respectives $Q_0$, $Q_1$, $Q_2$ et $Q_3$ un chiffre des unités et un chiffre des dizaines codés en code binaire, constituant un compte d'impulsions d'horloge du second signal d'horloge représentant la capacité instantanée "théorique" de la batterie B. En régime de charge, la sortie 10C du détecteur de régime 10 met à l'état "1" des entrées comptage-décomptage U/D des compteurs-décompteurs 22u et 22d pour que ceux-ci comptent des impulsions du second signal d'horloge jusqu'à ce que la capacité maximale de la batterie soit atteinte et corresponde à un compte égal à 99. En régime de décharge, ou bien seulement en régime d'autodécharge, la sortie 10C du détecteur de régime 10 est toujours à l'état "0" et commande un décomptage des impulsions du second signal d'horloge. Ce décomptage peut être arrêté dès que la capacité de la batterie a diminué jusqu'à un pourcentage déterminé, égal à 90%, de sa capacité maximale suite au déclenchement d'une recharge de batterie par le circuit logique 23.

Le circuit logique 23 comprend deux portes NON-ET 231u et 231d ayant chacune deux entrées reliées directement aux sorties $Q_0$ et $Q_3$ du compteur-décompteur respectif 22u, 22d et deux autres entrées reliées aux sorties $Q_1$ et $Q_2$ du compteur-décompteur respectif à travers des inverseurs 232u et 233u, 232d et 233d, afin de détecter les chiffres des unités et des dizaines du compte d'impulsions égaux à 9. Le circuit 23 comprend également une bascule bistable JK 234 ayant une entrée d'horloge C reliée à la sortie du diviseur 21 à travers un inverseur 235, une entrée J reliée à des sorties des portes 231u et 231d à travers une porte NON-OU à deux entrées 236, et une entrée K reliée directement à la sortie de la porte 231d.

Dès que la capacité instantanée de la batterie B atteint le taux de 99% indiqué par le circuit 22, les entrées J et K sont respectivement aux états "1" et "0" et suite à une impulsion sur l'entrée C de la bascule une sortie Q de la bascule 234 passe à l'état "1" afin de désactiver le circuit de régulation de charge 3 et ainsi éviter une surcharge de la batterie B. Cette désactivation est obtenue par la fermeture d'un contact 318 mettant au potentiel de terre une entrée du circuit de régulation 3 comme on le verra dans la suite. Suite à une décharge ou autodécharge de la batterie et donc un décomptage dans le circuit 22, la capacité instantanée de la batterie diminue de 99% à 90%, l'entrée J passe à l'état "0" et bloque la sortie Q à l'état "1", quelles que soient les impulsions appliquées à l'entrée C. Dès que la capacité instantanée de la batterie atteint une valeur inférieure à 90% l'entrée K passe à l'état "1", l'entrée J demeure à l'état "0" et la sortie Q passe à l'état "0" en réponse à une impulsion sur l'entrée C de la bascule, ce qui ouvre le contact 318 précité et autorise le circuit de régulation à recharger la batterie B. La commande de régulation traduite par l'état "0" à la sortie Q de la bascule 234 est maintenue tant que la capacité instantanée est inférieure à 90% et est même bloquée à cet état lorsque la batterie est rechargée pour une capacité de 90 à 99% correspondant à des états "0" des entrées J et K. Le passage de l'état "0" à l'état "1" de l'entrée J remet à l'état "1" la sortie Q et désactive le circuit de régulation 3 pour ne pas charger la batterie tant que la capacité instantanée de celle-ci n'a pas diminué jusqu'à 89%.

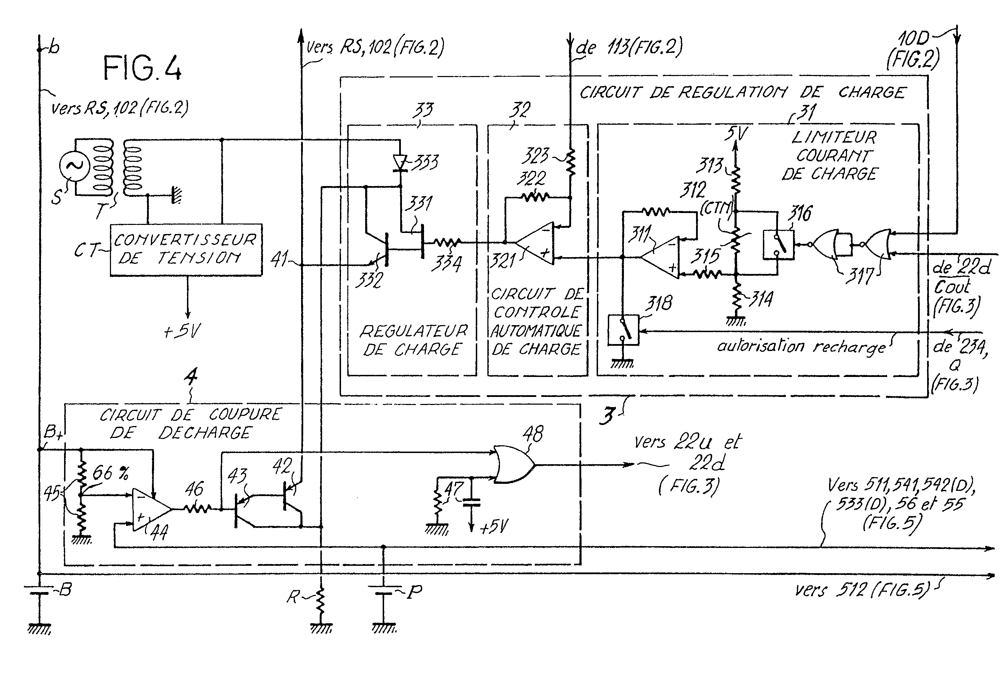

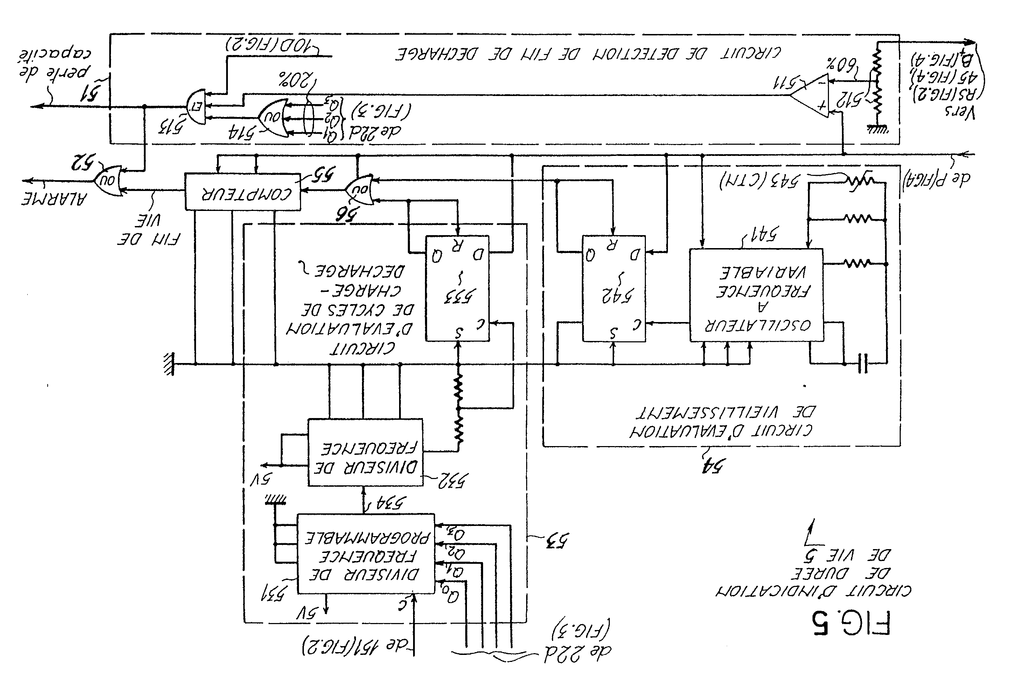

En référence à la Fig.4, le circuit de régulation de charge 3 comprend un limiteur de courant de charge 31, un circuit de contrôle automatique de charge 32 et un régulateur de charge 33.

Le limiteur de courant de charge 31 inclut un amplificateur opérationnel non inverseur 311 relié à un circuit d'entrée fournissant une tension fonction de la température grâce à une thermistance à coefficient de température négatif 312. La thermistance 312 est insérée entre une résistance 313 portée à 5 Volts et une résistance 314 portée à la terre, une borne commune à la résistance 314 et à la thermistance 312 étant reliée à une borne d'entrée directe "+" de l'amplificateur 311 via une résistance 315. Un contact 316 est connecté en parallèle à la thermistance 312 et est commandé par un circuit logique OU 317 ayant une première entrée reliée à la sortie 10D du détecteur de régime 10 et une seconde entrée reliée à une sortie de mise en cascade $\overline{C_{out}}$ du compteur-décompteur 22d. La sortie $\overline{C_{out}}$ de chaque compteur-décompteur 22µ, 22d est à l'état "0" lorsque le chiffre des unités ou des dizaines est égal à 9.

Le contact déjà cité 318 commandé par la sortie Q de la bascule 234 est interconnecté entre la terre et une borne de sortie de l'amplificateur 311 reliée à une entrée directe "+" d'un amplificateur opérationnel 321 inclus dans le circuit de contrôle 32. Dans le circuit une entrée inverse "-" de l'amplificateur 321 est reliée à une borne d'une résistance de contre-réaction 322 et à la sortie 113 de l'amplificateur 111 dans le circuit de prélèvement de tension 11 via une résistance 323.

Le régulateur de charge 33 est un régulateur de courant comprenant un transistor à effet de champ 331 et un transistor bipolaire NPN 332 ayant respectivement un drain et un collecteur reliés au transformateur T à travers une diode redresseuse 333 et à une borne de la résistance de charge R, et ayant une source et une base reliées entre elles. La grille du transistor 331 est reliée à une borne de sortie de l'amplificateur 321 via une résistance d'entrée 334. L'émetteur du transistor 332 est relié à une borne d'entrée 41 du circuit de coupure de décharge 4 et à la borne positive B₊ de la batterie B via la résistance shunt RS.

Comme déjà dit, le contact de commande 318 est ouvert dès que la capacité de la batterie est inférieure à 90% de sa capacité maximale.

Si la batterie cesse d'être en régime de décharge, le passage au régime de charge indiqué par l'état "0" à la sortie 10D ouvre le contact 316, la sortie $\overline{Cout}$ du compteur-décompteur 22d étant à l'état "0" c'est-à-dire la capacité chargée étant supérieure ou égale à 90%. La thermistance 312 intervient alors pour imposer une tension de référence fonction de la température à l'entrée directe de l'amplificateur de contrôle 321 qui est fonction de la température et qui est amplifiée par le niveau de charge imposé par la sortie 113 de l'amplificateur 111. Le limiteur de courant 31 limite ainsi tout courant de surcharge en fonction de la température.

Le circuit de coupure de décharge 4 est également montré à la Fig.4. Il comprend un interrupteur sous la forme d'un circuit de Darlington à deux transistors PNP 42 et 43, interconnecté entre la borne 41 et la résistance d'utilisation R pour couper la décharge de la batterie lorsque sa tension s'abaisse au dessous d'une tension dite d'arrêt. Le circuit 4 comprend également un comparateur de tension incluant un amplificateur opérationnel 44. L'amplificateur 44 compare une tension de référence égale à la tension de la pile P et appliquée à une borne d'entrée directe "+" de l'amplificateur 44 avec une tension appliquée à une borne d'entrée inverse "-" de l'amplificateur 44 et établie par un diviseur de tension 45 relié à la batterie B. La valeur de la tension d'arrêt est par exemple fixée à 75% environ de la tension nominale aux bornes de la batterie. La sortie de l'amplificateur 44 est reliée à une base du circuit de Darlington via une résistance 46 et bloque ainsi les transistors 42-43 pour déconnecter la batterie B de la résistance d'utilisation R lorsque la tension sur l'entrée de l'amplificateur 44 devient inférieure à la tension de la pile (3 volts), c'est-à-dire lorsque la tension aux bornes de la batterie chute en dessous de 4,5 volts. Pour ce faire, la fraction de tension prélevée par le diviseur de tension 45 est de 2/3 = 66% = 3/(6 x 0,75). Ainsi on évite toute inversion de polarité d'éléments de la batterie par une décharge trop importante.

Avant que la tension d'arrêt ne soit franchie, l'invention prévoit d'avertir l'utilisateur que le secteur est interrompu, c'est-à-dire que la batterie B est en régime de décharge et que l'installation représentée par la résistance d'utilisation R risque de ne plus être alimentée. Le circuit d'indication de durée de vie 5 montré à la Fig.5 permet d'indiquer, entre autres, une décharge prochaine de la batterie grâce à un signal d'alarme. A cette fin, le circuit 5 comprend un circuit de détection de fin de décharge 51 incluant un amplificateur opérationnel 511 ayant une entrée directe "+" reliée à la pile P et une entrée inverse "-" reliée à la batterie B à travers un diviseur de tension 512. L'amplificateur 511 réagira comme décrit ci-après, lorsque la tension délivrée par la batterie B descend en dessous d'un seuil prédéterminé, désigné "tension d'alarme", supérieur à la tension d'arrêt et sensiblement égal à 83% de la tension nominale de la batterie. Le franchissement de ce seuil prédéterminé est conventionnellement considéré comme une indication de décharge complète de la batterie et peut être exploité comme signal d'alarme. En pratique dans l'exemple de réalisation décrit, l'amplificateur 511 délivre un "1" lorsque le diviseur 512 délivre une tension inférieure à la tension de la pile P, c'est-à-dire lorsque la tension délivrée par la batterie devient inférieure à la tension d'alarme, soit 6 volts x 0,83 = 3 volts. Pour ce faire, le diviseur de tension 512 a un rapport de division égal à 60% = 3/(6 x 0,83). Le signal de sortie de l'amplificateur 511 est délivré à une entrée d'une porte ET 513 à trois entrées. Deux autres entrées de la porte 513 sont reliées à la sortie 10D du détecteur de régime et à une sortie d'une porte OU 514 respectivement. La porte 514 a trois entrées reliées aux sorties Q₁, Q₂ et Q₃ du compteur-décompteur 22d afin de détecter une capacité instantanée d'au moins 20% de la capacité théorique nominale de la batterie B. Ainsi, lorsque la batterie est en régime de décharge, la porte ET 513 transmettra une impulsion d'alarme de perte de capacité, si la tension de la batterie B atteint le seuil d'alarme avant que l'information en sortie de la porte OU 514 soit significative d'une décharge de 80% de la capacité nominale de la batterie. L'impulsion d'alarme est transmise via une porte OU à deux entrées 52.

Toujours en référence à la Fig.5, le circuit d'indication de durée de vie 5 comprend des moyens 53-54 pour évaluer des cycles de charge-décharge de la batterie et un vieillissement de la batterie en fonction de la température, afin de signaler une défaillance prochaine de la batterie B.

Un circuit d'évaluation de cycles de charge-décharge 53 est destiné à évaluer à la fois le nombre de cycles de charge-décharge et la profondeur des cycles, ces deux paramètres réduisant la durée de vie utile de la batterie B. Le circuit 53 comprend un diviseur de fréquence programmable 531, un diviseur de fréquence par 2¹⁸ 532 et une bascule D 533. Le diviseur de fréquence 531 reçoit par une entrée d'horloge C le signal d'horloge délivré par la sortie 151 du convertisseur tension-fréquence 15 et ayant une fréquence proportionnelle à l'intensité du courant de charge ou décharge, et par un bus d'adresses relié aux sorties $Q_0$ à $Q_3$ du second compteur-décompteur 22d, la capacité de la batterie à 10% près. Une sortie 534 du diviseur programmable 531 fournit à l'entrée du diviseur de fréquence 532 un signal de profondeur de décharge ayant une fréquence inversement proportionnelle à la capacité de batterie et réduite par rapport au signal d'horloge de charge ou décharge, et ainsi d'autant plus grande que la capacité de la batterie est faible pour un courant de décharge ou charge donné. Après division en fréquence dans le diviseur 532, le signal de profondeur est appliqué à une entrée d'horloge C de la bascule 533 ayant une sortie Q reliée à une entrée de remise à zéro R afin de mettre sous forme d'impulsions à largeur constante le signal de profondeur de décharge. Un compteur 55 compte les impulsions du signal de profondeur délivrées par la sortie Q de la bascule 533 via une porte OU à deux entrées 56.

Dans un circuit d'évaluation de vieillissement 54 inclus dans le circuit 5 sont prévus un oscillateur à fréquence variable 541 et une bascule D 542. L'oscillateur 541 comprend notamment une thermistance à coefficient de température négatif 543, afin de fournir un signal d'horloge ayant une fréquence variable en fonction de la température, et une fréquence nominale choisie f = 200 Hz en fonction d'une durée de vie moyenne déterminée préalablement de la batterie B. Par exemple, lorsque la température passe de 20°C à 40°C, la fréquence de l'oscillateur 541 est doublée afin de simuler une réduction de moitié de la durée de vie de la batterie. Le signal de vieillissement délivré par l'oscillateur 541 est appliqué à une entrée d'horloge C de la bascule 542 ayant une sortie Q reliée à une entrée R. Les impulsions du signal de vieillissement mises en forme par la bascule 542 sont également transmises au compteur 55 via la porte OU 56.

En fonction de critères indiqués par le constructeur de la batterie B, le compteur 55 a un compte maximal représentant la durée de vie de la batterie, c'est-à-dire à la fois sa durée de fonctionnement et un nombre de cycles de charge-décharge qu'elle peut subir pendant cette durée. Ainsi, lorsque le nombre d'impulsions du signal de profondeur et du signal de vieillissement atteint le compte maximal, une sortie du compteur 55 signale une "fin de vie" de la batterie via la porte OU 52. Les rapports de division dans le diviseur programmable 531 sont d'autant plus élevés que les profondeurs de décharge sont importantes. Par exemple, pour des profondeurs de décharge comprises entre 10% et 20%, 50 et 60% et 80 et 90%, le signal de profondeur comprend 100 à 211, 646 à 846 et 1429 à 1929 impulsions pour un courant de décharge donné. $7,3.10^{10}$ impulsions du signal de profondeur de décharge signalent par exemple 1800 cycles de décharge-charge avec une profondeur de 50%, traduite par un changement d'état de la sortie du compteur 55.

Par ailleurs la sortie de l'amplificateur 44 dans le circuit de coupure (Fig. 4) et la sortie d'un circuit à résistance-capacité 47 de détection de coupure d'alimentation sont reliées par l'intermédiaire d'une porte 48, aux entrées de remise à zéro R des compteurs-décompteurs 22u et 22d (Fig. 3) afin de réinitialiser le dispositif lorsque la batterie B est en fin de décharge ou est remplacée par une nouvelle batterie. Le compteur 55 est également remis à zéro en cas de changement de batterie.

## Revendications

1. Dispositif de contrôle d'une batterie d'accumulateurs (B) comprenant un détecteur de régime (10) pour détecter l'un des régimes de charge et décharge de la batterie (B), un circuit de prélèvement de tension (11) commandé par le détecteur (10) pour amplifier une tension aux bornes (a, b) d'une résistance (RS) en série avec la batterie en une tension amplifiée (113) en fonction d'un rendement de charge lorsqu'un régime de charge de la batterie est détecté, et en fonction d'un rendement de décharge lorsqu'un régime de décharge de la batterie est détecté, un convertisseur (15) pour convertir en fréquence ladite tension amplifiée en un signal d'horloge (151) ayant une fréquence variable proportionnelle à un courant de charge et décharge de la batterie et au rendement énergétique de la batterie estimé en fonction de la température, un circuit de commande (2) pour estimer la capacité instantanée de la batterie en fonction d'un comptage-décomptage d'impulsions du signal d'horloge, et un circuit de régulation (3) pour recharger la batterie (B) à partir d'une tension de secteur dès que la capacité instantanée est égale à une première capacité sensiblement inférieure à la capacité maximale de la batterie, caractérisé en ce qu'il comprend un circuit de simulation (12, 13) connecté au détecteur de régime (10) et au circuit d'amplification (11) pour soustraire ou additionner à ladite tension amplifiée une tension qui est proportionnelle à un courant d'autodécharge de la batterie (B) estimé en fonction de la température selon qu'un régime de charge ou un régime de décharge de la batterie est détecté, en des tensions soustraites ou additionnées converties par le convertisseur (15) en ledit signal d'horloge (151), et en ce que le circuit de régulation (3) sous le contrôle (318) du circuit de commande (2) régule la recharge de la batterie (B) en fonction du courant (113, 323) de charge et décharge traversant la batterie (B) et en fonction de la température.

2. Dispositif conforme à la revendication 1, caractérisé en ce qu'il comprend également un circuit d'évaluation de vieillissement (54, 55) pour évaluer le vieillissement de la batterie (B) par comptage d'impulsions dont la fréquence de répétition dépend de la température, du courant de charge et décharge, et de la capacité estimée de la batterie, afin de produire et transmettre un signal d'alarme lorsque le nombre d'impulsions comptées atteint une valeur prédéterminée.

3. Dispositif conforme à la revendication 2, caractérisé en ce que le circuit de prélèvement de tension (11) comprend un amplificateur (111) ayant deux bornes d'entrée reliées aux bornes (a, b) de ladite résistance en série (RS) à travers des premières résistances (102, 112) et des premiers contacts (11C) et à travers des secondes résistances (102) et des seconds contacts (11D), les premiers et seconds contacts (11C, 11D) étant fermés en réponse à un régime de charge détecté (10C) et un régime de décharge détecté (10D), respectivement, et les secondes et premières résistances (102 ; 102, 112) ayant des valeurs ohmiques dans un rapport sensiblement égal à un rendement énergétique de la batterie (B) correspondant à la capacité maximale de la batterie.

4. Dispositif conforme à la revendication 3, caractérisé en ce que les premières résistances (102, 112) comprennent des varistances (112).

5. Dispositif conforme à l'une quelconque des revendications 1 à 4, caractérisé en ce que le circuit de simulation (12-13) comprend un sommateur (13) ayant une première entrée (113) pour recevoir ladite tension amplifiée, une entrée de soustraction reliée à une thermistance (121) à travers un premier contact (12C) qui est fermé en réponse à un régime de charge détecté (10C), et une entrée d'addition reliée à ladite thermistance (121) à travers un second contact (12D) qui est fermé en réponse à un régime de décharge détecté (10D).

6. Dispositif conforme à l'une quelconque des revendications 1 à 7, caractérisé en ce que le circuit de commande (2) comprend un circuit de comptage-décomptage (21, 22) ayant un compte maximal représentatif de la capacité maximale de la batterie (B) pour compter et décompter les impulsions du signal d'horloge (151), des moyens (231, 232, 233, 236) pour détecter ledit compte maximal des moyens (231d, 232d, 233d) pour détecter un premier compte dans le circuit de comptage-décomptage (21, 22) représentatif de la première capacité, et des moyens (234, 235) pour autoriser le circuit de régulation (3) à recharger la batterie (B) dès que le compte du circuit de comptage et décomptage - de comptage et décomptage est inférieur au premier compte, puis tant que ledit compte n'est pas égal au compte maximal.

7. Dispositif conforme à l'une quelconque des revendications 1 à 6 caractérisé en ce que le circuit de régulation (3) comprend un limiteur de courant de charge (31) incluant en entrée une thermistance (312) en parallèle avec un premier contact (316), le premier contact (316) étant fermé lorsque la batterie (B) est en régime de décharge et a une capacité inférieure à la capacité maximale, et étant ouvert lorsque la batterie est en régime de charge, et un amplificateur (321) ayant une entrée reliée à une sortie du limiteur de courant (31) et à la terre à travers un second contact (318) commandé par le circuit de commande (2), une entrée de contre-réaction recevant ladite tension amplifiée appliquée par le circuit de prélèvement de tension (11) et proportionnelle à un courant de charge et décharge, et une sortie reliée à une entrée de commande du régulateur de charge (33), le second contact (318) étant ouvert dès que la capacité de la batterie (B) est inférieure à ladite première capacité, puis tant que la capacité de la batterie n'est pas égale à la capacité maximale.

8. Dispositif conforme à l'une quelconque des revendications 1 à 7, caractérisé en ce qu'il comprend un interrupteur de courant (42, 43) entre la batterie (B) et un circuit d'utilisation (R), et un comparateur de tension (44, 45) pour comparer une tension de référence avec un premier pourcentage (66%) de la tension aux bornes de la batterie (B) afin de commander une déconnexion de la batterie (B) et du circuit d'utilisation (R) dans l'interrupteur (42, 43) lorsque ledit premier pourcentage de tension est inférieur à la tension de référence.

9. Dispositif conforme à l'une quelconque des revendications 1 à 8, caractérisé en ce qu'il comprend un comparateur de tension (511, 512) pour comparer une tension de référence avec un second pourcentage (60%) de la tension aux bornes de la batterie (B) afin de transmettre un signal d'alarme lorsque ledit second pourcentage est inférieur à la tension de référence.

10. Dispositif conforme à la revendication 9, caractérisé en ce qu'il comprend des moyens (514, 513) reliés un circuit de commande (2) pour détecter une capacité résiduelle très inférieure à la première capacité en vue de transmettre ledit signal d'alarme lorsque ledit second pourcentage de tension (60%) devient inférieur à la tension de référence, avant que la capacité résiduelle de la batterie ait été détectée.

11. Dispositif conforme à la revendication 8 et à la revendication 9 ou 10, caractérisé en ce que le premier pourcentage (66%) est supérieur au second pourcentage (60%).

12. Dispositif conforme à l'une quelconque des revendications 8 à 11, caractérisé en ce que ladite tension de référence est appliquée par une pile (P).

13. Dispositif conforme à l'une quelconque des revendications 1 à 12, caractérisé en ce qu il comprend un circuit d'évaluation de cycles (53, 55) pour engendrer une information indiquant la profondeur d'un cycle lors de chaque cycle de charge et décharge de la batterie, et pour cumuler lesdites informations pour transmettre un signal d'alarme lorsque les informations cumulées dépassent une valeur prédéterminée.

14. Dispositif conforme à la revendication 13, caractérisé en ce que le circuit d'évaluation de cycles comprend un diviseur de fréquence programmable (531) pour diviser la fréquence du signal d'horloge (151) en fonction de la capacité instantanée dans le circuit de régulation (3), et des moyens pour compter (533, 55) des impulsions du signal d'horloge divisé en fréquence afin de transmettre un signal d'alarme en réponse à un compte prédéterminé d'impulsions.

15. Dispositif conforme à la revendication 2, caractérisé en ce que les circuit d'évaluation de vieillissement comprend un oscillateur à fréquence variable (541) incluant une thermistance (543), et des moyens (542, 55) pour compter les impulsions à fréquence variable sortant de l'oscillateur.

16. Dispositif conforme aux revendications 14 et 15, caractérisé en ce que les deux moyens pour compter dans le circuit d'évaluation de cycles (53, 55) et le circuit d'évaluation de vieillissement (54, 55) comprennent un unique compteur (55) ayant une entrée d'horloge reliée par une porte OU (56) recevant le signal d'horloge divisé en fréquence et les impulsions sortant de l'oscillateur (541).

## Claims

1. Control device for a storage battery (B) comprising a rate detector (10) for detecting one of the charging and discharging rates of the battery (B), a voltage taking circuit (11) controlled by the detector (10) for amplifying a voltage to the terminals (a,b) of a resistor (RS) connected in series with the battery into an amplified voltage (113) as a function of a charge efficiency when a charging rate is detected, and as a function of a discharge efficiency when a discharging rate of the battery is detected, a converter (15) for frequency converting said amplified voltage into a clock signal (151) having a variable frequency proportional to a charge and discharge current of the battery and to the battery energy efficiency evaluated as a function of the temperature, a controlling circuit (2) for estimating the instantaneous capacity of the battery as a function of a clock signal up-down counting, and a regulating circuit (3) for recharging the battery (B) from a mains voltage as soon as the instantaneous capacity is equal to a first capacity substantially lower than the maximum capacity of the battery, characterized in that it comprises a simulation circuit (12,13) connected to the rate detector (10) and to the amplifying circuit (1) for subtracting from or adding to said amplified voltage a voltage which is proportional to a self-discharge current of the battery (B) estimated as a function of the temperature according as a charging rate or a discharging rate of the battery (B) is being detected, into subtracted or added voltages converted by the converter (15) into said clock signal (151), and in that the regulating circuit (3) under the control (318) of the controlling circuit (2) regulates the recharge of the battery (B) as a function of the charge and discharge current (113,323) flowing through the battery and as the function of the temperature.

2. Device according to claim 1, characterized in that it also comprises an ageing estimating circuit (54,55) for estimating the ageing of the battery (B) by counting pulses of which the repetition frequency depends on the temperature, the charge and discharge current, and the estimated capacity of the battery, thereby producing and transmitting an alarm signal when the number of the counted pulses reaches a predeterminated value.

3. Device according to claim 2, characterized in that the voltage taking circuit (11) comprises an amplifier (111) having two input terminals connected to the terminals (a,b) of said series resistor (RS) through first resistors (102,112) and first contacts (11C) and through second resistors (102) and second contacts (110), the first and second contacts (11C, 11D) being closed in response to a detected charging rate (10C) and a detected discharging rate (10D) respectively, and the second and first resistors (102;102,112) having resistances in a ratio substantially equal to an energy efficiency of the battery (B) corresponding to the maximum capacity of the battery.

4. Device according to claim 3, characterized in that the first resistors (102,112) comprise varistors (112).

5. Device according to any one of claims 1 to 4, characterized in that the simulation circuit (12-13) comprises an adder (13) having a first input (113) to receive said amplified voltage, a subtraction input connected to a thermistor (121) via a first contact (12C) which is closed in response to a detected charging rate (10C), and an addition input connected to said thermistor (121) via a second contact (12D) which is closed in response to a detected discharging rate (10D).

6. Device according to any one of claims 1 to 4, characterized in that the controlling circuit (2) comprises an up-down counting circuit (21-22) having a maximum count representative of the maximum capacity of the battery (B) for up-down counting the pulses of the clock signal (151), means (231,232,233,236) for detecting said maximum count, means (231d, 232d, 233d) for detecting a first count in the up-down counting circuit (21,22) representative of the first capacity, and means (234,235) for authorizing the regulating circuit (3) to recharge the battery (B) as soon as the count in the up-down counting circuit is less than the first count, then as long as said count is not equal to the maximum count.

7. Device according to any one of claims 1 to 6, characterized in that the regulating circuit (3) comprises a charge current limiter (31) including on input a thermistor (312) in parallel with a first contact (316), the first contact (316) being closed when the battery (B) is in discharging rate and has a capacity lower than the maximum capacity, and being opened when the battery is in charging rate, and a amplifier (321) having an input connected to an output of the current limiter (31) and to the ground via a second contact (318) controlled by the controlling circuit (2), a negative-feedback input receiving said amplified voltage (113) applied by the voltage taking circuit (11) and proportional to a charge and discharge current, and an output connected to a control input (3) of the charge regulating circuit (3), the second contact (318) being opened as soon as the battery (B) capacity is lower than said first capacity, then as long as the battery capacity is not equal to said maximum capacity.

8. Device according to any one of claims 1 to 7, characterized in that it comprises a current switch (42,43) between the battery (B) and a load circuit (R), and a voltage comparator (44,45) for comparing a reference voltage with a first voltage percentage (66%) on battery (B) terminals thereby controlling a disconnection of the battery (B) and of the load means (R) in the switch (42,43) when said first voltage percentage is lower than the reference voltage.

9. Device according to any one of claims 1 to 8, characterized in that it comprises a voltage comparator (511,512) for comparing a reference voltage with a second voltage percentage (60%) on battery (B) terminals thereby transmitting an alarm signal when said second percentage is lower than the reference voltage.

10. Device according to claim 9, characterized in that it comprises means (514,513) connected to a controlling circuit (2) for detecting a residual capacity well less than the first capacity thereby transmitting said alarm signal when said second voltage percentage (60%) becomes less than the reference voltage, before being detected the residual capacity of the battery.

11. Device according to claim 8 and to claim 9 or 10, characterized in that the first percentage (66%) is more than the second percentage (60%).

12. Device according to any one of claims 8 to 11 characterized in that said reference voltage is supplied from a battery cell (P).

13. Device according to any one of claims 1 to 12, characterized in that it comprises a cycle estimating circuit (53,55) for deriving an information indicating the depth of a cycle during each battery charge and discharge cycle, and for cumululating said informations to transmit an alarm signal when the cumulated informations exceed a predetermined value.

14. Device according to claim 13, characterized in that the cycle estimating circuit comprises a programmable frequency divider (531) for dividing the frequency of the clock signal (151) as a function of the instantaneous capacity in the regulating circuit (3), and means for counting (533,55) frequency-divided clock signal pulses thereby transmitting an alarm signal in response to a predeterminated pulse count.

15. Device according to claim 2, characterized in that the ageing estimating circuit comprises a variable frequency oscillator (541) including a thermistor (543), and means (542,55) for counting variable frequency pulses delivered from the oscillator.

16. Device according to claims 14 and 15, characterized in that the two counting means in the cycle estimating circuit (53,55) and the ageing estimating circuit (54,55) comprise one single counter (55) having a clock input connected through an OR gate (56) receiving the frequency-divided clock signal and pulses outgoing from the oscillator (541).

**Ansprüche**

1. Vorrichtung zur Überwachung einer Akkumulatorenbatterie (B), umfassend einen Betriebszustandsdetektor (10) zum Erfassen des einen der Aufladungs- und Entladungsbetriebszustände der Batterie (B), einen durch den Detektor gesteuerten Spannungsabgriffskreis (11) zum Verstärken einer Spannung an den Anschlüssen (a, b) eines Widerstandes (RS) in Reihe mit der Batterie zu einer verstärkten Spannung (113) abhängig von einer Aufladungsgrad, wenn ein Aufladungszustand der Batterie erfaßt wird, und abhängig von einem Entladungsgrad, wenn ein Entladungsbetriebszustand der Batterie erfaßt wird, einen Wandler (15) zum Frequenzumwandeln der verstärkten Spannung zu einem Taktsignal (151), das eine veränderliche Spannung proportional zu einem Aufladungs- und Entladungsstrom der Batterie und zum abhängig von der Temperatur ermittelten energetischen Wirkungsgrad der Batterie aufweist, einen Steuerkreis (2) zum Ermitteln der augenblicklichen Kapazität der Batterie abhängig von einer Aufwärtszählung-Abwärtszählung von Impulsen des Taktsignals, und einen Regelkreis (3) zum Wiederaufladen der Batterie (B) von einer Netzspannung, sowie die augenblickliche Kapazität gleich einer ersten Kapazität ist, die deutlich kleiner als die maximale Kapazität der Batterie ist, dadurch **gekennzeichnet**, daß sie einen mit dem Betriebszustandsdetektor (10) und mit dem Verstärkerkreis (11) verbundenen Simulationskreis (12, 13) umfaßt, um von der verstärkten Spannung eine Spannung zu subtrahieren oder zu dieser zu addieren, die zu einem Selbstentladungsstrom der Batterie (B) proportional ist, der abhängig von der Temperatur ermittelt wird, je nachdem ein Aufladungsbetriebszustand oder ein Entladungsbetriebszustandder Batterie erfaßt worden ist, zu Substrahier- oder Addierspannungen, die durch den Wandler (15) zu dem Taktsignal (150) umgewandelt werden, und daß der Regelkreis (3) unter der Überwachung (318) des Steuerkreises (2) die Wiederaufladung der Batterie (B) abhängig von dem durch die Batterie (B) fließenden Aufladungs- und Entladungsstrom (113, 323), und abhängig von der Temperatur regelt.

2. Vorrichtung nach Anspruch 1, dadurch **gekennzeichnet**, daß sie in gleicher Weise einen Alterungsbeurteilungskreis (54, 55) zur Beurteilung der Alterung der Batterie (B) durch Zählen von Impulsen umfaßt, deren Wiederholfrequenz von der Temperatur, dem Aufladungs- und Entladungsstrom und der ermittelten Kapazität der Batterie abhängig ist, um ein Alarmsignal zu erzeugen und zu übertragen, wenn die Zahl von gezählten Impulsen einen vorbestimmten Wert erreicht.

3. Vorrichtung nach Anspruch 2, dadurch **gekennzeichnet**, daß der Spannungsabgriffskreis (11) einen Verstärker (111) umfaßt, der zwei Eingangsanschlüsse aufweist, die durch erste Widerstände (102, 112) und erste Kontakte (11C) und durch zweite Widerstände (102) und zweite Kontakte (11D) mit den Anschlüssen (a, b) des Reihenwiderstandes (RS) verbunden sind, wobei die ersten und zweiten Kontakte (11C, 11D) ansprechend auf einen erfaßten Aufladungszustand (10C) und einen erfaßten Entladungszustand (10D) jeweils geschlossen sind und wobei die zweiten und ersten Widerstände (102; 102, 112) Ohm'sche Werte in einer Beziehung im wesentlichen gleich einer Energieausbeute der Batterie (B) entsprechend der maximalen Kapazität der

**4.** Vorrichtung nach Anspruch 3, dadurch **gekennzeichnet,** daß die ersten Widerstände (102, 112) Varistoren (112) umfassen.

**5.** Vorrichtung nach einem beliebigen der Ansprüche 1 bis 4, dadurch **gekennzeichnet,** daß der Simulationskreis (12-13) ein Summierglied (13) umfaßt, das einen ersten Eingang (113) zum Aufnehmen der verstärkten Spannung, einen Subtrahiereingang, der mit einem Thermistor (121) durch einen Kontakt (12C) verbunden ist, der ansprechend auf einen erfaßten Aufladungsbetriebszustand (10C) geschlossen wird, und einen Addiereingang aufweist, der mit dem Thermistor (121) durch einen zweiten Kontakt (12D) verbunden ist, der ansprechend auf einen erfaßten Entladungsbetriebszustand (10D) geschlossen wird.

**6.** Vorrichtung nach einem beliebigen der Ansprüche 1 bis 7, dadurch **gekennzeichnet,** daß der Steuerkreis (2) einen Aufwärtszähl-Abwärtszählkreis (21, 22), der eine für die maximale Kapazität der Batterie (B) repräsentative maximale Zählung aufweist, um die Impulse des Taktsignals (151) aufwärts- und abwärtszuzählen, Mittel (231, 232, 233, 236) zum Erfassen der maximalen Zählung, Mittel (231d, 232d, 233d) zum Erfassen einer ersten Zählung im für die erste Kapazität repräsentativen Aufwärtszähl-Abwärtszählkreis (21, 22) und Mittel (234, 235) umfaßt, um zu gestatten, daß der Regelkreis (3) die Batterie (B) wieder auflädt, sobald die Zählung des Aufwärtszähl- und Abwärtszählkreises niedriger als die erste Zählung ist, dann solange die Zählung nicht gleich der maximalen Zählung ist.

**7.** Vorrichtung nach einem beliebigen der Ansprüche 1 bis 6, dadurch **gekennzeichnet,** daß der Regelkreis (3) einen Ladestrombegrenzer (31), der im Eingang einen Thermistor (312) parallel zu einem ersten Kontakt (316) einschließt, wobei der erste Kontakt (316) geschlossen ist, wenn sich die Batterie (B) im Entladungsbetriebszustand befindet und eine Kapazität kleiner als die maximale Kapazität aufweist, und offen ist, wenn sich die Batterie im Aufladungsbetriebszustand befindet, und einen Verstärker (321) umfaßt, der einen Eingang, der mit einem Ausgang des Strombegrenzers (31) und mit der Erde durch einen durch den Steuerkreis (2) gesteuerten zweiten Kontakt (318) verbunden ist, einen Rückkopplungseingang, der die verstärkte Spannung (113) aufnimmt, die durch den Spannunsababgriffskreis (11) angelegt wird und zu einem Aufladungs- und Entladungsstrom proportional ist, und einen Ausgang einschließt, der mit einem Steuereingang des Ladungsreglers (33) verbunden ist, wobei der zweite Kontakt (318) offen ist, sobald die Kapazität der Batterie (B) kleiner als die erste Kapazität ist, dann solange die Kapazität der Batterie nicht gleich der maximalen Kapazität ist.

**8.** Vorrichtung nach einem beliebigen der Ansprüche 1 bis 7, dadurch **gekennzeichnet,** daß sie einen Stromschalter (42, 43) zwischen der Batterie (B) und einem Verbraucherstromkreis (R) und einen Spannungsvergleicher (44, 45) zum Vergleichen einer Bezugsspannung mit einem ersten Prozentsatz (66%) der Spannung an den Anschlüssen der Batterie (B) umfaßt, um ein Abschalten der Batterie (B) und des Verbraucherstromkreises (R) im Schalter (42, 43) zu betätigen, wenn der ersten Spannungsprozentsatz kleiner als die Bezugsspannung ist.

**9.** Vorrichtung nach einem beliebigen der Ansprüche 1 bis 8, dadurch **gekennzeichnet,** daß sie einen Spannungskomparator (511, 512) zum Vergleichen einer Bezugsspannung mit einem zweiten Prozentsatz (60%) der Spannung an den Anschlüssen der Batterie (B) umfaßt, um ein Alarmsignal zu übertragen, wenn der zweite Prozentsatz kleiner als die Bezugsspannung ist.

**10.** Vorrichtung nach Anspruch 9, dadurch **gekennzeichnet,** daß sie mit einem Steuerkreis (2) verbundene Mittel (514, 513) umfaßt, um eine Restkapazität zu erfassen, die sehr klein zur ersten Kapazität hinsichtlich der Übertragung des Alarmsignals ist, wenn der zweite Prozentsatz (60%) kleiner als die Bezugsspannung wird, bevor die Restkapazität der Batterie erfaßt worden ist.

**11.** Vorrichtung nach Anspruch 8 und nach Anspruch 9 oder 10, dadurch **gekennzeichnet,** daß der erste Prozentsatz (66%) höher als der zweite Prozentsatz (60%) ist.

**12.** Vorrichtung nach einem beliebigen der Ansprüche 8 bis 11, dadurch **gekennzeichnet,** daß die Bezugsspannung durch ein Element (P) angelegt wird.

**13.** Vorrichtung nach einem beliebigen der Ansprüche 1 bis 12, dadurch **gekennzeichnet,** daß sie einen Zy__klusauswertekreis (53, 55) zur Erzeugung einer Information, die die Tiefe eines Zyklus zur Zeit eines jeden Aufladungs- und Entladungszyklus der Batterie anzeigt, und zum Ansammeln der Informationen umfaßt, um ein Alarmsignal zu übertragen, wenn die angesammelten Informationen einen vorbestimmten Wert übersteigen.

14. Vorrichtung nach Anspruch 13, dadurch **gekennzeichnet**, daß der Zyklusauswertekreis einen programmierbaren Frequenzteiler (531) zum Teilen der Frequenz des Taktsignals (151) abhängig von der augenblicklichen Kapazität im Regelkreis (3) und Mittel zum Zählen (533, 55) der Impulse des frequenzgeteilten Taktsignals umfaßt, um ein Alarmsignal ansprechend auf eine vorbestimmte Zählung von Impulsen zu übertragen.

15. Vorrichtung nach Anspruch 2, dadurch **gekennzeichnet**, daß der Kreis zur Alterungsbeurteilung einen durchstimmbaren Oszillator (551), der einen Thermistor (543) einschließt, und Mittel (542, 55) zum Zählen der aus dem Oszillator austretenden Impulse mit veränderlicher Frequenz umfaßt.

16. Vorrichtung nach den Ansprüchen 14 und 15, dadurch **gekennzeichnet**, daß die beiden Mittel zum Zählen in dem Zyklusauswertekreis (53, 55) und dem Kreis zur Alterungsbeurteilung (54, 55) einen einzigen Zähler (55) umfassen, der einen Takteingang aufweist, der durch ein ODER-Gatter (56) verbunden ist, das das frequenzgeteilte Taktsignal und die aus dem Oszillator (541) austretenden Impulse aufnimmt.

# FIG.1

décharge    charge    CIRCUIT DE SURVEILLANCE DE REGIME DE CHARGE OU DECHARGE (FIG. 2)    charge/décharge

b    RS    151

a

S    T    CIRCUIT DE REGULATION DE CHARGE (FIG.4)    22d Cout    CIRCUIT DE COMMANDE DE CHARGE (FIG.3)    22d, Q₀ à Q₃

41    3    autorisation de recharge    234,Q    2

CT    CONVERTISSEUR DE TENSION

+5V    CIRCUIT DE COUPURE DE DECHARGE (FIG.4)    4    5    CIRCUIT D'INDICATION DE DUREE DE VIE (FIG.5)

B₊    B    R    P    Alarme

EP 0 216 662 B1

FIG. 2

CIRCUIT DE SURVEILLANCE DE REGIME 1

# FIG.3

de 151 (FIG.2)

Vers 531 (FIG.5)

+5V DIVISEUR DE FREQUENCE 21

CIRCUIT DE COMMANDE DE CHARGE 2

22

23

CIRCUIT DE COMPTAGE-DECOMPTAGE

CIRCUIT D'AUTORISATION DE RECHARGE

+5V

UNITE

$Q_0$ $Q_1$ $Q_2$ $Q_3$

232u 233u

231u

$R'$ C U/D 22u

Cout

de 10C (FIG.2)

+5V

DIZAINE

$Q_0$ $Q_1$ $Q_2$ $Q_3$

232d 233d

231d

20% Vers 531, 514 (FIG.5)

$R'$ C U/D 22d

Cout

de 4B (FIG.4)

Vers 317 (FIG.4)

5V

234 90%

C K

235

236

Vers 318 (FIG.4)

Q J

99%

autorisation de recharge

FIG.4

CIRCUIT DE REGULATION DE CHARGE

LIMITEUR COURANT DE CHARGE

REGULATEUR DE CHARGE

CIRCUIT DE CONTROLE AUTOMATIQUE DE CHARGE

CIRCUIT DE COUPURE DE DECHARGE

CONVERTISSEUR DE TENSION

vers RS, 102 (FIG.2)

Vers RS, 102 (FIG.2)

de 113 (FIG.2)

10D (FIG.2)

de 22d Cout (FIG.3)

de 234, Q (FIG.3)

autorisation recharge

Vers 22u et 22d (FIG.3)

Vers 511, 541, 542 (D), 533 (D), 56 et 55 (FIG.5)

vers 512 (FIG.5)

EP 0 216 662 B1

## FIG. 5

CIRCUIT D'INDICATION
DE DUREE
DE VIE 5